# EUROPEAN PATENT SPECIFICATION

(11) **EP 0 240 020 B1**
(45) Date of publication and mention of the grant of the patent: **03.03.1993**
(21) Application number: 87104886.4
(22) Date of filing: 02.04.1987
(51) Int. Cl.: G01D 5/24, G01B 7/02

(54) **A capacitance type transducer for measuring positions**
Kapazitanztransduktor für Positionsmessung
Un transducteur à capacitance pour la mesure de positions

(30) Priority: 04.04.1986 JP 78948/86
(43) Date of publication of application: 07.10.1987
(73) Proprietor: MITUTOYO CORPORATION, Tokyo 108 (JP)
(72) Inventor: Andermo, Ingvar, Kirkland, WA 98033 (US)
(74) Representative: Grünecker, Kinkeldey, Stockmair & Schwanhäusser Anwaltssozietät

(56) References cited:
- EP-A- 0 053 091
- GB-A- 2 009 944
- GB-A- 2 118 720
- US-A- 3 222 591

## Description

This invention relates to a capacitance type transducer for measuring the amount of relative displacement between two scales according to the preamble part of claim 1. Specifically, it relates to an improved capacitance type transducer for measuring positions in which the amount of displacement between a pair of moving structural members which are displaced relatively to each other can be measured accurately by means of changes in electrostatic capacity.

Electrical length-measuring devices are well known. These are electrical length-measuring devices in which two scales are displaced relatively to each other, and the relative displacement positions of both of the aforesaid scales are measured by means of changes in the electrostatic capacity between electrodes positioned on both scales. They can be used in a broad range of applications, from large-size length-measuring devices such as three-dimensional measuring devices or numerically controlled finishing machines, to portable calipers, micrometers and other small-size length-measuring devices.

The capacitance type transducers used in these length-measuring devices supply their transmitting electrodes with A.C. signals, preferably A.C. signals with a number of different phases, have electrical measuring circuits connected to the corresponding receiving electrodes, and use the changes in the electrostatic capacity caused by the relative displacement between both electrodes to measure specific positions.

In the capacitance type transducers of the past for detecting positions, as is well known, the precision was determined by the number of divisions of the electrodes provided on each scale. In order to obtain length-measuring devices with a high resolution in the past, either the transmitting electrodes or the receiving electrodes, or both, were miniaturized in order to make high-precision measurement possible.

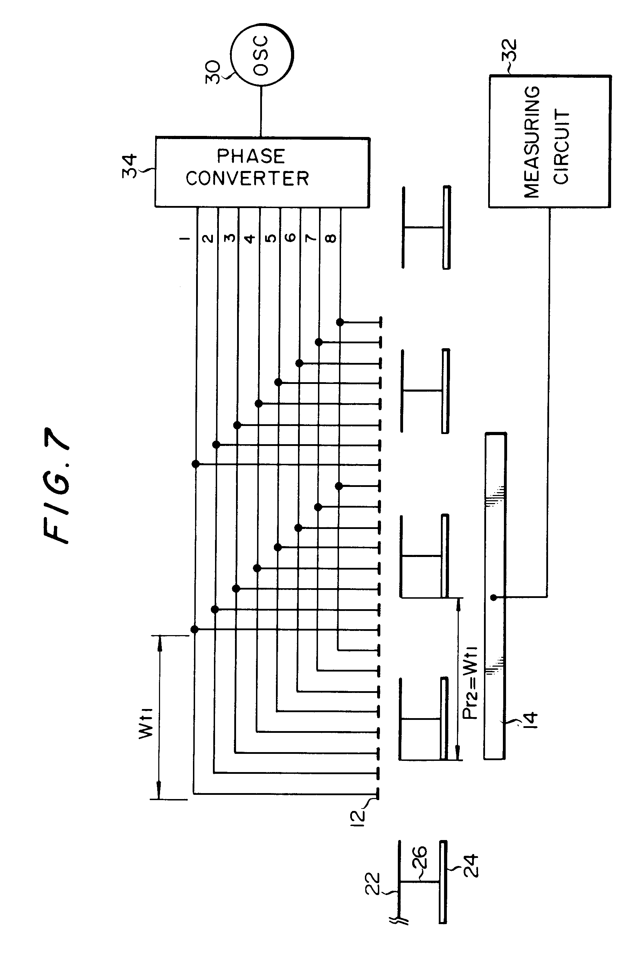

From GB-A-2 009 944 a high resolution capacitance type transducer is known. The basic principles of this apparatus will be described in the following with reference to Fig 7. The device has a first scale and a second scale which are positioned adjacent to each other in a manner so that they can be displaced relatively to each other. If the transducer is to be incorporated for example in a length-measuring device such as calipers, the second scale of the transducer is mounted on the regular scale of the calipers, and the first scale of the transducer is mounted on the vernier scale of the calipers.

The first scale and second scale are provided with either transmitting electrodes or receiving electrodes which are coupled capacitively with each other, and when there is relative displacement between both scales the relative positions of both of them are detected electrically by means of the changes in the electrostatic capacity.

In Fig. 7, a number of first transmitting electrodes 12 are positioned with equal spacing on the first scale on the vernier scale side, and A.C. signals are supplied to these first transmitting electrodes from an oscillator 30. In this example, the A.C. signals are converted by a phase converter 34 into signals with eight different phases, and these are supplied to each of the transmitting electrodes 12.

Consequently, in Fig. 7, the A.C. signals each have phase differences of 45 degrees, and the eight first transmitting electrodes 12, combined as a block, are supplied with A.C. signals each having a different phase.

In the figure, the pitch of the group of first transmitting electrodes 12 combined in a block as described above is shown by transmitting wavelength pitch Wt1.

On the other hand, a number of second receiving electrodes 22 are positioned in a row with equal spacing on the second scale on the regular scale side. In the figure, the second receiving electrodes 22 are positioned to correspond with the group of first transmitting electrodes 12 formed in each of the aforesaid blocks. As a result, one can understand that the pitch Pr2 of the second receiving electrodes 22 is equal to the aforesaid transmitting wavelength pitch Wt1 on the transmitting side.

Consequently, if this device of the past is applied, it will be possible to detect positions with a precision equal to the pitch Pr2 of the second receiving electrodes divided into eight parts, and it will be possible to supply a high-resolution transducer.

Naturally, in a device with such a high resolution, the transducer can make absolute measurements only within the range of the pitch Pr2 of the second receiving electrodes, and it becomes unable to determine absolute positions when the pitch Pr2 is exceeded. Therefore, the device LS1 may be said to be basically suited to making relative measurements.

The second transmitting electrodes 24 are electrically conducted to each of the aforesaid second receiving electrodes 22 by means of coupling electrodes 26. The aforesaid second transmitting electrodes 24 are coupled capacitively with the first receiving electrode 14, which is positioned in parallel with the aforesaid first transmitting electrodes 12 on the first scale. As a result, the signals supplied to the first transmitting electrodes 12 from the phase converter 34 are first coupled capacitively between them and the second receiving electrodes 22; next they are electrically conducted to the second transmitting electrodes 24, after which they are again detected as electrical signals by the first receiving electrode 14 on the first scale by means of capacitive coupling.

The output of the aforesaid first receiving electrode 14 is given electrical processing in the measuring circuit 32.

However, a problem in transducers with such minute divisions as that in Fig. 7 was that the electrodes were miniaturized to such a pronounced degree that machining techniques of an extremely high precision were needed in order to position them accurately on the scales.

Ordinarily the aforesaid electrodes are formed by methods such as vapor deposition on insulating substrates. However, the problem when the aforesaid finely divided electrodes were relied on in order to obtain length-measuring devices with a high resolution was that it was extremely difficult to machine them, and this necessarily led to increases of costs of the devices.

This invention was made in consideration of the aforesaid tasks of the past, and its purpose is to provide high-resolution transducers which do not require mechanical division of the electrodes themselves into minute divisions.

This object is solved by an apparatus comprising the characterizing features of claim 1.

That is, when this invention is applied, unlike the minute division of the past, in which a single receiving electrode pitch is divided into integral fractions, a number of groups of transmitting electrodes and receiving electrodes are positioned facing each other as a number of different groups, and the differences between the numbers of both electrodes are taken out as beat signals. As a result, the electrodes themselves are positioned with a large pitch, which is easy to machine, but their resolution itself can be set quite finely by means of the aforesaid beats.

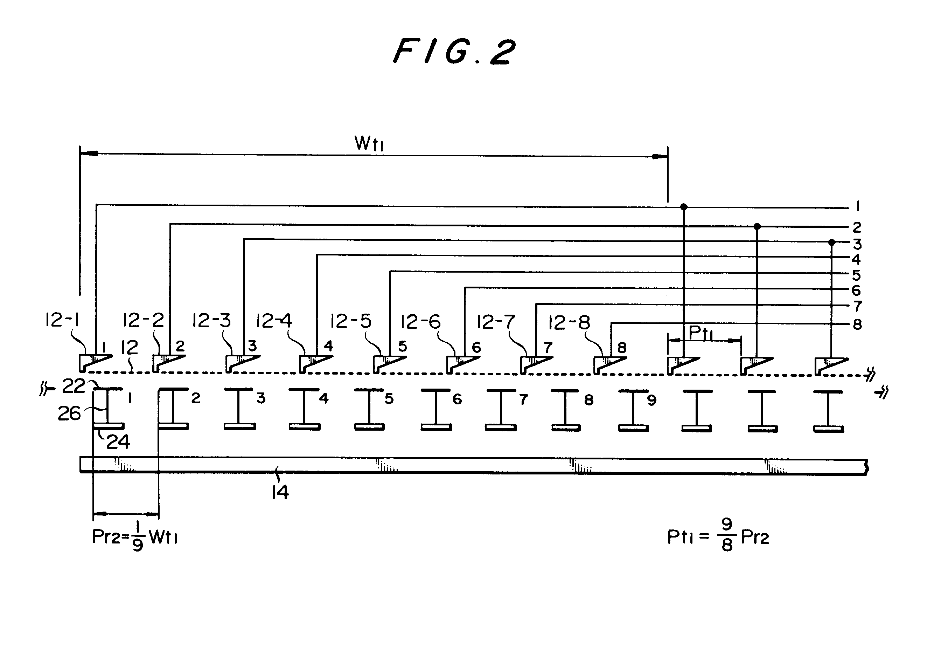

The aforesaid basic principles of this invention are illustrated in Fig. 2.

The same structural members as those in the devices of the past shown in Fig. 7 are assigned the same symbols in Fig. 2, and explanations of them are omitted.

An important feature of this invention is the fact that, whereas the first transmitting electrodes in the past were each divided into a number of divisions in correspondence with the second receiving electrodes 22, now the transmitting electrodes are extracted one by one from the transmitting wavelength pitch Wt1 of the past, and these electrodes are greatly enlarged and positioned.

That is, as is clear from Fig. 2, only the first electrode is taken out from the first transmitting wavelength pitch Wt1 of the past, i.e., from the group of eight transmitting electrodes, enlarged as shown by symbol 12-1, and used as the first transmitting electrode. The other electrodes were eliminated.

Similarly, the second electrode 12-2 was taken out from the first block of transmitting electrodes, and the others were eliminated. After this, the first transmitting electrodes were taken out one by one, as shown by 12-3, 12-4 ....12-8.

Consequently, one can understand that the transmitting wavelength pitch Wt1 has been enlarged eightfold in comparison with the past.

Therefore, as is clear from the diagram illustrating the basic principles in Fig. 2, one can understand that on the receiving side the receiving electrodes are formed from a number of electrodes with an equally spaced pitch obtained by dividing the length of the aforesaid group of transmitting electrodes, i.e. the transmitting wavelength pitch Wt1, by a predetermined integer, in this case 9.

Therefore, one can understand that in Fig. 2 the second receiving electrode pitch Pr2 will be 1/9 × Wt1.

As is clear from this diagram illustrating the basic principles, one can understand that the first transmitting electrodes 12 taken out in Fig. 2 are each in a similar relationship to the nine second receiving electrodes 22 positioned in a row as the miniature first transmitting electrodes with respect to the receiving electrodes in Fig. 7. That is, in Fig. 2 also, if both scales are displaced relatively to each other, the relative displacement between the transmitting electrodes and the receiving electrodes can be thought to be exactly the same as in Fig. 7. The only difference is that in Fig. 2 the displacement must be determined by a length spanning nine receiving electrodes.

Nevertheless, such a difference means only that, in a length-measuring device such as calipers, the breadth of the vernier scale will be wider than in the past. In actual fact, since the breadth of the vernier scale is large enough in comparison with the width of each of the transmitting electrodes, the aforesaid characteristic feature will not constitute a factor preventing in any way the practical application of the actual devices.

Fig. 1 is an approximate oblique drawing illustrating a suitable embodiment of the capacitance type transducer of this invention for measuring positions.

Fig. 2 is an explanatory drawing illustrating the basic principles of this invention.

Fig. 3 is a layout drawing of the electrodes illustrating another embodiment of an application of this invention.

Fig. 4 is a layout drawing of the electrodes illustrating still another embodiment of an application of this invention.

Fig. 5 is a circuit diagram illustrating an embodiment of the measuring circuit for processing the detection signals obtained from the transducer of this invention.

Fig. 6 is an explanatory diagram showing the wave patterns and a timing chart for Fig. 5.

Fig. 7 is an explanatory diagram of a transducer using the miniaturized electrodes of the past.

In the following we explain a preferable embodiment of an application of this invention on the basis of the drawings.

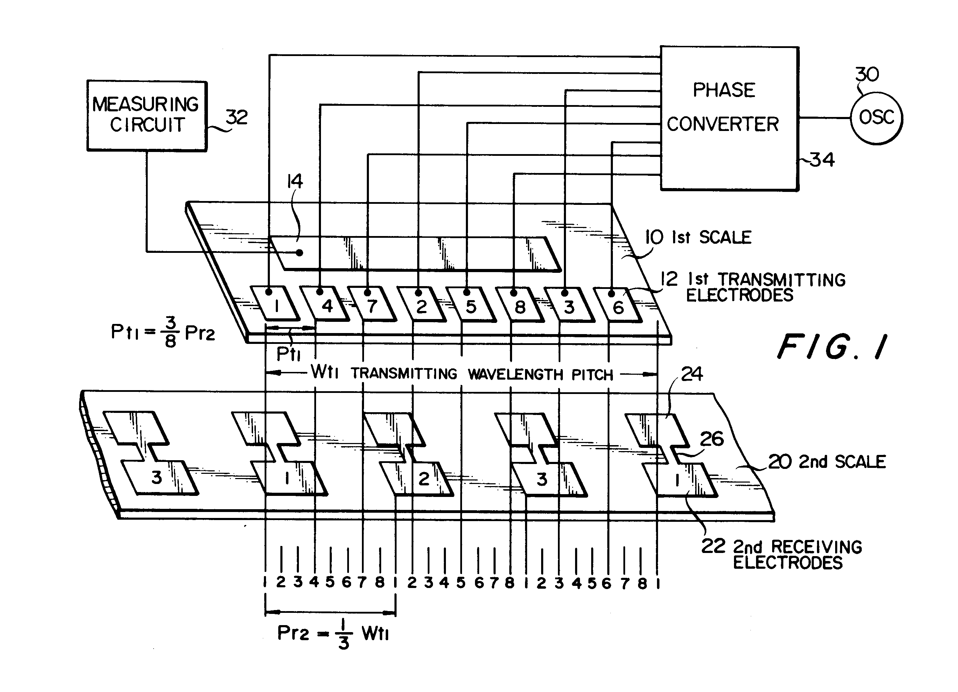

The structural members in Fig. 1 which are the same as those described above in Fig. 7 are assigned the same symbols, and explanations of them are omitted.

In the figure, the first scale is given the numeral 10, and the second scale is given the numeral 20. Both scales are incorporated in the vernier scale and the regular scale, for example of calipers, are adjacent to each other, and are displaced relatively to each other.

Therefore, one can understand that capacitive coupling is performed between the first transmitting electrodes 12 provided on the first scale 10 and the second receiving electrodes 22 provided on the second scale 20.

Consequently, if the aforesaid first transmitting electrodes 12 are provided, from the oscillator 30 and the phase converter 34, with a number of A.C. signals having different phases, these A.C. signals will still retain data about the capacity value between electrodes 12 and 22 when they are transmitted to the second scale 20 side. These signals will also be conducted electrically by means of coupling electrodes 26 to the second transmitting electrodes 24 on the second scale 20 and will be returned to the first scale 10 side by the capacitive coupling between the second transmitting electrodes 24 and the first receiving electrode 14 provided on the first scale 10 side. The desired arithmetical processing will be performed by the measuring circuit 32.

Therefore, when this embodiment is applied, the circuitry penetrating through the transducer for capacity measurement is formed by a single circuit, and there is no fear of mechanical errors in the devices or of other errors such as caused by differences in the electrical delay time. Thus, one can understand that the stability is increased remarkably, for example when compared with the devices of the past in which two trains of transmitting and receiving circuits were combined.

A characteristic feature of this invention is the electrode positioning of the first transmitting electrodes 12 and the second receiving electrodes 22, as described above. In this embodiment, the transmitting electrodes 12 form a single group of eight electrodes for receiving eight different A.C. signals, each with an electrical phase difference of 45 degrees.

Therefore, the length of this group forms the transmitting wavelength pitch Wt1. The pitch between each of the transmitting electrodes is shown in the figure by Pt1. In this embodiment, the receiving electrodes consist of a number of electrodes 22 with equally spaced pitch obtained by dividing the length of the aforesaid group of transmitting electrodes, i.e. the transmitting wavelength pitch Wt1 by a predetermined integer. In this embodiment, the number of these divisions is set at "3."

Although in this embodiment the integer by which the aforesaid transmitting wavelength pitch Wt1 is divided is a number smaller than the number of transmitting electrodes 12 within the transmitting wavelength pitch Wt1, this is not an essential feature of this invention. In actual fact, it is desirable to make the electrode pitch Pr2 of the second scale 20 spanning the entire length of the scale as large as possible. This is useful for the sake of simplifying machining of the electrodes on the second scale.

As a result of the above, the second receiving electrodes 22 are positioned in the 1-2-3 sequence within the transmitting wavelength pitch Wt1, and the receiving electrode pitch Pr2 will have a value of
1/3 Wt1

On the other hand, in keeping with this positioning of the second receiving electrodes 22, the aforesaid first transmitting electrodes 12 will have a pitch Pt1 of
3/8 Pr2

The sequence in which the A.C. signals are supplied to them is determined as shown in the figure in order to facilitate processing in the measuring circuit 32.

That is, when the receiving electrode pitch Pr2 is divided by the number of transmitting electrodes (the number being 8 in this embodiment), A.C. signals corresponding to the divided positions on the aforesaid receiving electrode pitch will be supplied to each of the transmitting electrodes 12. In this embodiment, the A.C. signals are supplied in the following order, starting from the left: 1, 4, 7, 2, 5, 8, 3, 6. It is not essential in this invention that the signals be supplied in such a sequence, but in cases where the number of receiving electrodes is less than the number of transmitting electrodes, unlike the case in Fig. 2, which illustrates the basic principles, it is desirable for both electrodes to be positioned as shown in the drawing in the sequence of their phase differences. This will be helpful later in facilitating the processing of the detected signals.

In Fig. 1, the pitch Pt1 of the first transmitting electrodes is given as
3/8 Pr2

As described above, as is clear from the embodiment shown in Fig. 1, in this invention the receiving electrodes 22 are positioned at an equally spaced pitch, obtained by dividing the transmitting electrode wavelength pitch Wt1 by an integer. Therefore, it will be possible to detect positions with a scale precision equal to the number of transmitting electrodes within the group of transmitting electrodes 12 with a receiving electrode pitch Pr2, i.e. 1/8.

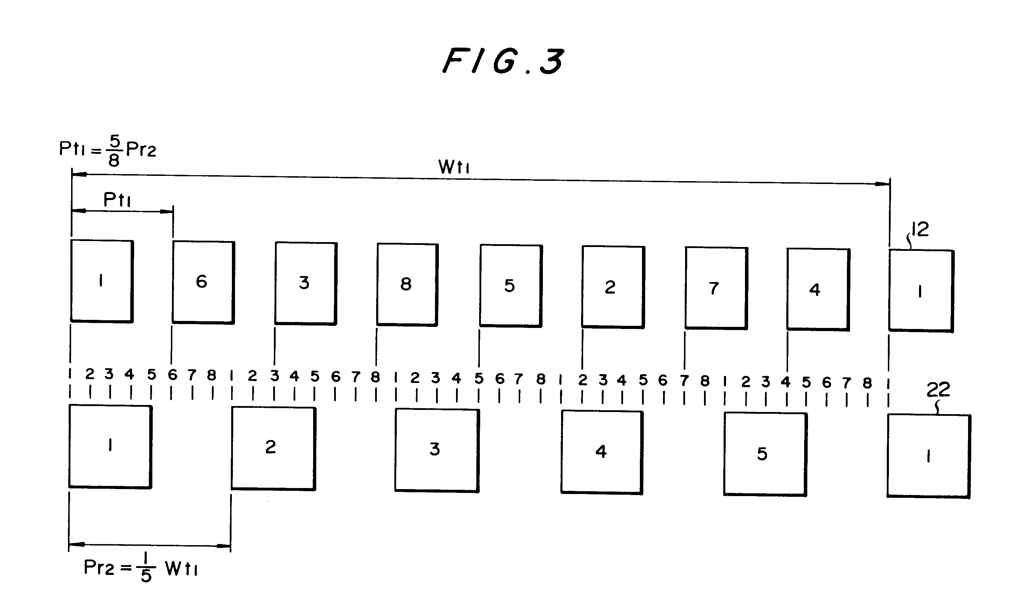

Fig. 3 illustrates another combination of the transmitting and receiving electrodes in this invention.

In the embodiment in Fig. 3, the transmitting electrodes 12 receive A.C. signals of eight different phases, as in Fig. 1. Their transmitting wavelength pitch is indicated by Wt1, and the electrode pitch is indicated by Pt1. The receiving electrodes 22 in this embodiment have a configuration in which the aforesaid transmitting wavelength pitch Wt1 is divided into "five" parts. As a result, the receiving electrode pitch Pr2 will be
1/5 Wt1

In this embodiment also, the sequence in which the signals are supplied to the transmitting electrodes 12 is determined by the positions at which the receiving electrode pitch Pr2 is divided by eight, the number of transmission signals. In the figure, the signals are supplied in the following sequence, starting from the left: 1, 6, 3, 8, 5, 2, 7, 4.

In the embodiment in Fig. 3, the transmitting electrode pitch Pt1 is set at
5/8 Pr2

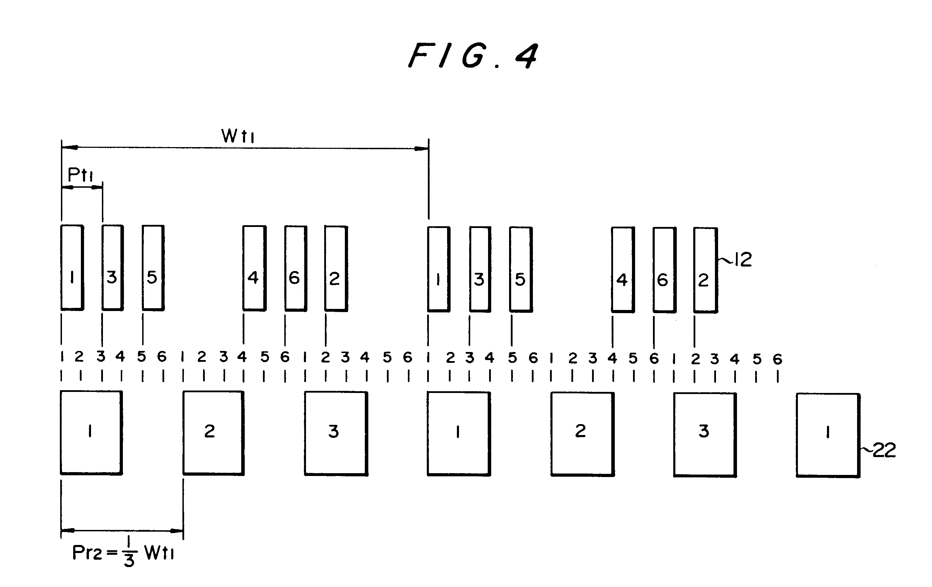

Fig. 4 illustrates still another embodiment of this invention. A characteristic feature of this embodiment is the fact that the transmitting electrodes 12 are spaced at unequal intervals.

That is, in the embodiment in Fig. 4, six transmitting electrodes form a group and determine the transmitting wavelength pitch, but the electrode pitch Pt1 within this group is not uniform, and the electrodes are divided into three smaller sub-blocks.

Nevertheless, even in this type of device, if the receiving electrode 22 side is arranged in a row with equal intervals, it will be possible to perform good position-detecting operations without losing the advantages of this invention.

Of course, even with this sort of unequally spaced arrangement, the sequence in which the A.C. signals are supplied is determined by the position obtained by dividing the receiving electrode pitch Pr2 by the number of transmitting electrodes, in the same way as described above. In this embodiment, the sequence of 1, 3, 5, 4, 6, 2 is selected.

In this embodiment, as is shown in the figure, the receiving electrode pitch Pr2 is selected as
1/3 Wt1

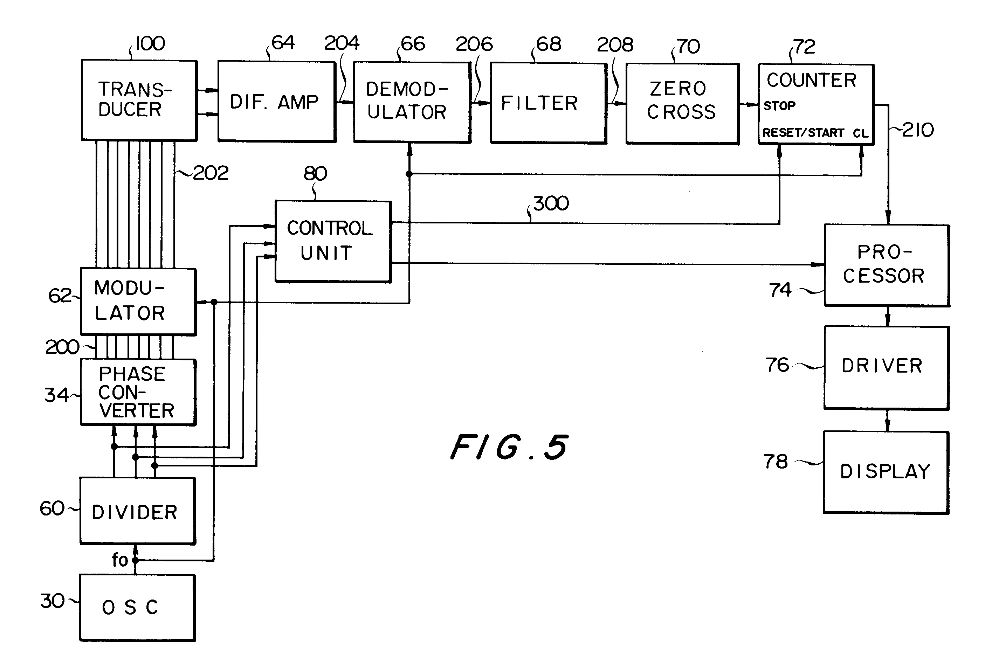

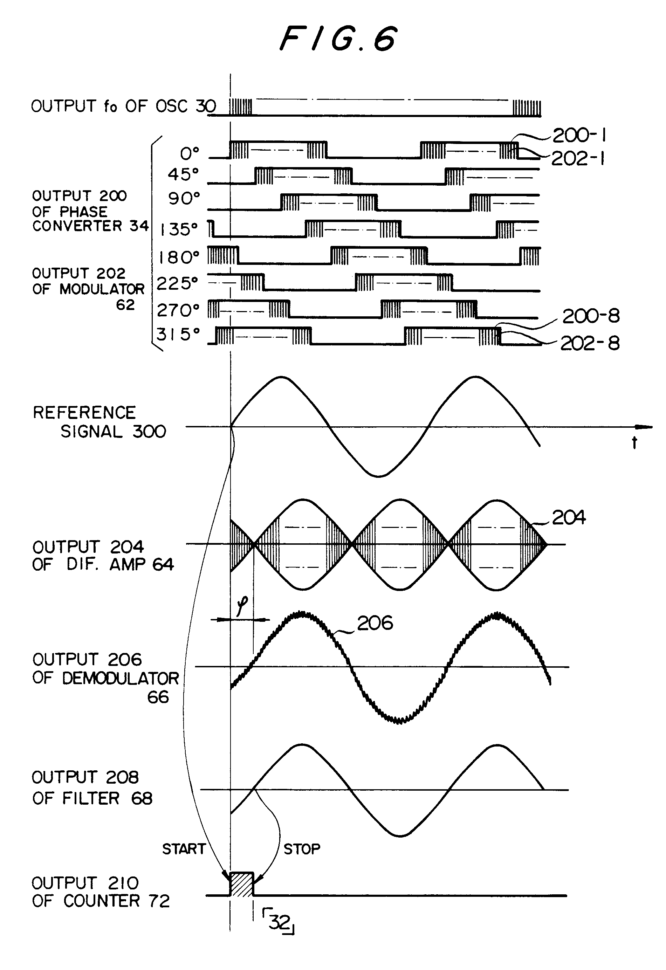

Fig. 5 illustrates an embodiment of a length-measuring circuit connected to a transducer of this invention as described above. Fig. 6 shows the wave patterns at its various parts and a timing chart.

The transducer of this invention, described above, is shown by the numeral 100. A.C. signals with a number of different phases are supplied to its first transmitting electrodes. These A.C. signals are obtained from the oscillator 30. The frequency of this oscillator output f₀ does not need to be very high in this invention, and output of a relatively low frequency, for example of around 100-200 kHz, can be used.

The output f₀ of the aforesaid oscillator 30 is subjected to further frequency division by the frequency divider 60, and the resulting signals are supplied to the transducer 100. The signals are also used as synchronizing signals for the modulator and demodulator, and they comprise one of the factors for determining the resolution of the device. However, since this basic frequency, as well as the frequencies of the A.C. signals which have undergone frequency division and are supplied to the first transmitting electrodes, are low, as was mentioned above, this invention has the effect that a sufficient resolution can be obtained with inexpensive devices with a simplified circuit configuration.

The output of the aforesaid frequency divider 60 is further converted by the phase converter 34 into the desired eight A.C. signals 200-1 to 200-8 which each have electrical phase differences of 45 degrees. Therefore, it is desirable for these eight A.C. signals with different phases to be supplied to first transmitting electrodes such as those of Fig. 1, as described above.

The aforesaid eight A.C. signals are modulated in the modulator 62 with the output f₀ of the aforesaid oscillator 30, and these signals 200-1 to 200-8 are supplied to the first transmitting electrodes 12 of the transducer 100.

After the aforesaid A.C. signals 202 have been supplied to the transducer 100, as mentioned above, they undergo conversion of their signal levels corresponding to the relative displacement positions of the first and second scales. Then they are output as electrical signals from the first receiving electrode. This output is output from the differential amplifier 64 as signal 204. One can understand that this will be a signal with an envelope describing a sinusoidal curve, as is shown in Fig. 6.

The output 204 of this differential amplifier 64 will be further demodulated by the demodulator 66, and one can understand that its output 206 will have a phase difference φ in comparison with the reference signal 300 when both scales are at their reference positions. By finding this phase difference φ, one can find an absolute value determined by the relative positions of both scales.

Incidentally, the output 206 of the aforesaid demodulator 66 contains high-frequency components, as is shown in the figure. In this embodiment, these high-frequency components are removed by a filter 68 to obtain a signal 208 from which high-frequency components have been removed.

The aforesaid signal 208 then goes into the zero-crossing circuit 70, where the zero-crossing position of the wave pattern is detected.

In this embodiment, since the aforesaid phase difference φ is calculated digitally, the device includes a counter 72. In this embodiment, its reset/start signals are synchronously controlled by the trigger signals of the modulator 62 and demodulator 66 and by the control unit 80. Starting of measurements by the device is used as the trigger for the reference signal, and the counter 72 begins its counting operations from this time. The timing of counting by the counter 72 is controlled by the output frequency f₀ of the oscillator 30.

Stopping of the counting by the counter 72 is controlled by signals from the aforesaid zero-crossing circuit 70. At the phase φ position in Fig. 6, the aforesaid zero-crossing circuit 70 outputs a stop signal to the counter 72 from the output 208 of the filter 68, and the counting operations of the aforesaid counter 72 stop at this time.

Consequently, the count value of the aforesaid counter 72 will indicate the phase difference by which the reference signal 300 has been shifted by the transducer. As mentioned above, when this invention is applied, this phase difference φ will correspond to the deviation D (x) between both scales 10 and 20 at the time of measurement, and the output of the aforesaid counter 72 will be processed by the arithmetic unit 74 to convert it to an absolute value.

The output of the arithmetic unit 74, which is controlled by the control unit 80, passes through the display driver 76 and supplies the desired display signal to the display unit 78. The aforesaid measured values are ordinarily displayed digitally.

In this embodiment, the aforesaid display unit 78 may consist of a liquid-crystal display unit embedded and fastened onto the surface of, for example, the vernier scale of calipers. This enables the user to read the measured value of the length easily.

As was explained above, if this invention is applied, it is possible to measure positions with a high resolution without miniaturizing the transmitting or receiving electrodes. In particular, this is extremely useful for inexpensive, portable, battery-driven length-measuring devices.

## Claims

1. A capacitance type transducer for measuring positions comprising a first scale (10) and a second scale (20) which are positioned adjacent to each other in a manner so that they can be relatively displaced along a measurement axis,
the first scale (10) is provided with first transmitting electrodes (12) arranged in the direction of the measurement axis and forming at least one group of electrodes spanning a transmitting wavelength pitch (Wt1) and to which a number of A.C. signals with different phases are respectively supplied; and a first receiving electrode (14) which is electrically isolated from the aforesaid first transmitting electrodes (12),
the aforesaid second scale (20) is provided with second receiving electrodes (22) which consist of a group of electrodes which are arranged with an equally spaced pitch (Pr2) in the direction of measurement axis so as to be coupled capacitively with the aforesaid first transmitting electrodes (12), and second transmitting electrodes (24) which consist of a group of electrodes which are arranged in the direction of the measurement axis so as to be coupled capacitively with the aforesaid first receiving electrode (14),
the corresponding electrodes in the aforesaid second receiving electrodes (22) and second transmitting electrodes (24) are each electrically coupled with each other conductively by coupling electrodes (26),
**characterized in that,**
the second receiving electrodes (22) are arranged with an equally spaced pitch (Pr2), which is obtained by dividing the transmitting wavelength pitch (Wt1) of the aforesaid group of first transmitting electrodes (12) by a predetermined integer N having a value greater than one, and
that a scale precision amounting to a fraction of the number of first transmitting electrodes (12) within the aforesaid group of first transmitting electrodes (12) of the aforesaid receiving electrode pitch (Pr2) is possible.

2. The capacitance type transducer according to claim 1, **characterized in that** the second receiving electrode pitch (Pr2) is obtained by dividing the transmitting wave length pitch (Wt1) of the aforesaid group of first transmitting electrodes (12) by an integer N less than the number of first transmitting electrodes (12) within the group of first transmitting electrodes.

3. The capacitance type transducer according to claim 1 or 2, **characterized in that** the first transmitting electrodes (12) have an unequally spaced pitch (Pt1).

4. The capacitance type transducer according to any one of the preceding claims 1 to 3, **characterized in that** the sequence of the phases of the A.C. signals supplied to the first transmitting electrodes (12) in the aforesaid group is determined according to the division of the second receiving electrode pitch (Pr2) by the number of first transmitting electrodes (12) in the aforesaid group, so that A.C. signals having phases in a sequence corresponding to divided positions of the aforesaid second receiving electrode pitch (Pr2) are supplied to each of the first transmitting electrodes (12) in the aforesaid group according to the respective relative divided positions at which the first transmitting electrodes (12) are located in the aforesaid group.

5. The capacitance type transducer according to any one of the preceding claims 1 to 4, **characterized in that** the first receiving electrodes (14) sense the output signals produced by the second transmitting electrodes (24) capacitively coupled to said first transmitting electrodes (12) in response to said A.C. signals with different phases for producing an output signal which represents a sum of the sensed second electrode output signal, and that
a measuring circuit (32) is provided for deriving measurement data from said first receiving electrodes (14) output signal.

6. The capacitance type transducer according to any one of the preceding claims 1 to 5, **characterized in that** there are provided signal generator means (30, 34) for generating a number of signals which are successively incrementally phase shifted from each other in the steps of 360° divided by the number of signals and each of these signals is applied to the respective one of the first transmitting electrodes (12) in the aforesaid group of transmitting electrodes.

7. The capacitance type transducer according to any one of the preceding claims 1 to 6, **characterized in that** the first transmitting electrodes (12) within each of said transmitting electrode groups are grouped in at least two sub-groups, the transmitting electrodes in each of said sub-groups being uniformally spaced from each other by a first pitch and said sub-groups being uniformally spaced from each other by a second pitch different from said first pitch.

8. The capacitance type transducer according to any one of the preceding claims dependent on claim 5, **characterized in that** the measuring circuit (32) comprises means (68) for filtering high frequency components from said first receiving electrodes (14) output signal to obtain substantially sinusodal measurement signal, and means (70, 72) for measuring the phases of said measurement signal relative to one of said A.C. signals to obtain measurement data.

9. The capacitance type transducer according to any one of the preceding claims 1 to 8, **characterized in that** the first scale (10) and second scale (20) are used as either the regular scale or the vernier scale of calipers.

## Patentansprüche

1. Kapazitiver Meßwertumformer zur Lagemessung mit einem ersten Maßstab (10) und einem zweiten Maßstab (20), welche naheliegend zueinander so positioniert sind, daß sie relativ entlang einer Meßachse verschoben werden können, wobei
der erste Maßstab (10) erste Sendeelektroden (12) aufweist, die in der Richtung der Meßachse ausgerichtet sind, und wenigstens eine Gruppe von Elektroden bilden, welche einen Sendewellenlängenabstand (Wt1) umspannen und an die eine Anzahl von Wechselstromsignalen mit verschiedenen Phasen entsprechend angelegt werden; und eine erste Empfangselektrode (14), die elektrisch von den genannten ersten Sendeelektroden (12) isoliert ist,
der genannte zweite Maßstab (20) zweite Empfangselektroden (22) aufweist, die aus einer Gruppe von Elektroden bestehen, die mit gleichem Abstand (Pr2) voneinander in der Richtung der Meßachse angeordnet sind, um so kapazitiv mit den genannten ersten Sendeelektroden (12) gekoppelt zu werden, und zweite Sendeelektroden (24), die aus einer Gruppe von Elektroden bestehen, die in der Richtung der Meßachse angeordnet sind, um so kapazitiv mit der genannten ersten Empfangselektrode (14) gekoppelt zu werden,
die entsprechenden Elektroden der genannten zweiten Empfangselektroden (22) und die zweiten Sendeelektroden (24) elektrisch leitend miteinander über Koppelelektroden (26) gekoppelt sind,
**dadurch gekennzeichnet,**
daß die zweiten Empfangselektroden (22) mit einem gleichen Abstand (Pr2) voneinander angeordnet sind, welcher durch Teilen des Sendewellenlängenabstands (Wt1) der genannten Gruppe von ersten Sendeelektroden (12) durch eine vorbestimmte ganze Zahl N mit einem Wert größer als Eins erhalten wird, und
daß eine Maßstabsgenauigkeit, welche gleich einem Bruchteil der Anzahl der ersten Sendeelektroden innerhalb der genannten Gruppe von ersten Sendeelektroden (12) des genannten Empfangselektrodenabstands (Pr2) möglich ist.

2. Kapazitiver Meßwertumformer nach Anspruch 1, **dadurch gekennzeichnet,** daß der zweite Empfangselektrodenabstand (Pr2) durch Teilen des Sendewellenlängeabstands (Wt1) der genannten Gruppe von ersten Sendeelektroden (12) durch eine ganze Zahl N, welche geringer als die Anzahl der ersten Sendeelektroden (12) innerhalb der Gruppe der ersten Sendeelektroden ist, erhalten wird.

3. Kapazitiver Meßwertumformer nach Anspruch 1 oder 2, **dadurch gekennzeichnet,** daß die ersten Sendeelektroden (12) verschieden große Abstände (Pt1) voneinander besitzen.

4. Kapazitiver Meßwertumformer nach einem der vorangehenden Ansprüche 1 bis 3, **dadurch gekennzeichnet,** daß die Sequenz der Phasen der Wechselstromsignale, welche an die ersten Sendeelektroden (12) in der genannten Gruppe angelegt werden, durch Teilen des zweiten Empfangselektrodenabstandes (Pr2) durch die Anzahl der ersten Sendeelektroden (12) in der genannten Gruppe bestimmt wird, so daß die Wechselstromsignale Phasen in einer Sequenz besitzen, die den geteilten Positionen des zweiten Empfangselektrodenabstandes (Pr2) entspricht, an jede der ersten Sendeelektroden (12) in der genannten Gruppe gemäß den entsprechenden relativ geteilten Positionen, an denen die ersten Sendeelektroden (12) in der genannten Gruppe angeordnet sind, angelegt werden.

5. Kapazitiver Meßwertumformer nach einem der vorangehenden Ansprüche 1 bis 4, **dadurch gekennzeichnet,** daß die ersten Empfangselektroden (14) die Ausgangssignale abtasten, welche von den zweiten Sendeelektroden (24) erzeugt werden, die kapazitiv mit den ersten Sendeelektroden (12) gekoppelt sind, im Ansprechen auf die genannten Wechselstromsignale mit verschiedenen Phasen, um ein Ausgangssignal zu erzeugen, welches die Summe des abgetasteten Ausgangssignals der zweiten Elektroden repräsentiert, und daß eine Meßschaltung (32) bereitgestellt wird, zum Ableiten von Meßdaten vom Ausgangssignal der ersten Empfangselektroden (14).

6. Kapazitiver Meßwertumformer nach einem der vorangehenden Ansprüche 1 bis 5, **dadurch gekennzeichnet,** daß eine Signalerzeugungseinrichtung (30, 34) bereitgestellt ist, zur Erzeugung einer Anzahl von Signalen, welche sukzessive bezüglich der Phase in Schritten von 360° geteilt durch die Anzahl der Signale zunehmen und daß jedes dieser Signale an eine entsprechende der ersten Sendeelektroden (12) in der genannten Gruppe von Sendeelektroden angelegt wird.

7. Kapazitiver Meßwertumformer nach einem der vorangehenden Ansprüche 1 bis 6, **dadurch gekennzeichnet,** daß die ersten Sendeelektroden (12) in jeder der genannten Gruppen von Sendeelektroden in wenigstens zwei Untergruppen gruppiert sind, wobei die Sendeelektroden in jeder der genannten Untergruppen mit einem ersten Abstand gleichmäßig voneinander beabstandet sind und die genannten Untergruppen mit einem zweiten Abstand, welcher verschieden von dem ersten Abstand ist, gleichmäßig voneinander beabstandet sind.

8. Kapazitiver Meßwertumformer nach einem der vorangehenden Ansprüche, die auf Anspruch 5 rückbezogen sind, **dadurch gekennzeichnet,** daß die Meßschaltung (32) eine Einrichtung (68) umfaßt zum Filtern von Hochfrequenzkomponenten von dem Ausgangssignal der ersten Empfangselektroden (14), um ein im wesentlichen sinusförmiges Meßsignal zu erhalten, sowie eine Einrichtung (70, 72) zum Messen der Phasen des Meßsignals relativ zu einem der genannten Wechselstromsignale, um Meßdaten zu erhalten.

9. Kapazitiver Meßwertumformer nach einem der vorangehenden Ansprüche 1 bis 8, **dadurch gekennzeichnet,** daß der erste Maßstab (10) und der zweite Maßstab (20) entweder als die normale Skala oder die Noniusskala von Maßlehren verwendet werden.

## Revendications

1. Transducteur à capacitance pour la mesure de positions comprenant une première échelle (10) et une seconde échelle (20) qui sont placées à côté l'une de l'autre d'une manière telle qu'elles peuvent subir un déplacement relatif le long d'un axe de mesure,
la première échelle (10) est munie de premières électrodes d'émission (12) disposées dans la direction de l'axe de mesure et formant au moins un groupe d'électodes couvrant un pas de la longueur d'onde d'émission (Wt 1) et auxquelles est fourni un certain nombre de signaux C.A. (courant alternatif) de différentes phases ; et une première électrode de réception (14) qui est électriquement isolée des premières électrodes d'émission (12) susdites ,
la seconde échelle susdite (20) est munie de secondes électrodes de réception (22) qui comprennent un groupe d'électrodes qui sont disposées selon un pas d'égale distance (Pr2) dans la direction de l'axe de mesure afin d'être en couplage capacitif avec les premières électrodes d'émission susdites (12), et de secondes électrodes d'émission (24) qui comprennent un groupe d'électrodes qui sont disposées dans la direction de l'axe de mesure afin d'être en couplage capacitif avec la première électrode de réception susdite (14),
les électrodes correspondantes dans les secondes électrodes de réception susdites (22) et les secondes électrodes d'émission (24) sont, chacune, couplées électriquement l'une avec l'autre de façon conductrice par des électrodes de couplage (26) ,
caractérisé en ce que,
les secondes électrodes de réception (22) sont disposées selon un pas d'égale distance (Pr2) qui est obtenu en divisant le pas de la longueur d'onde d'émission (Wt1) du groupe susdit des premières électrodes d'émission (12) par un entier prédéterminé N de valeur supérieure à un, et
en ce qu'une précision d'échelle se montant à une fraction du nombre des premières électrodes (12) dans le groupe susdit des premières électrodes d'émission (12) du pas susdit des électrodes de réception (Pr2) est possible.

2. Transducteur à capacitance selon la revendication 1, caractérisé en ce que le pas des secondes électrodes de réception (Pr2) est obtenu en divisant le pas de longueur d'onde d'émission (Wt1) du groupe susdit des premières électrodes d'émission (12) par un entier N inférieur au nombre de premières électrodes d'émission (12) dans le groupe des premières électrodes d'émission.

3. Transducteur à capacitance selon la revendication 1 ou 2, caractérisé en ce que les premières électrodes d'émission (12) possèdent un pas d'inégale distance (Pt1).

4. Transducteur à capacitance selon l'une quelconque des revendications précédentes 1 à 3, caractérisé en ce que la séquence des phases des signaux C.A. fournis aux premières électrodes d'émission (12) dans le groupe susdit est déterminée selon la division du pas des secondes électrodes de réception (Pr2) par le nombre de premières électrodes d'émission (12) dans le groupe susdit, de sorte que les signaux C.A. ayant des phases dans une séquence correspondant aux positions divisées du pas susdit des secondes électrodes de réception (Pr2), sont fournis à chacune des premières électrodes d'émission (12) du groupe susdit selon les positions divisées relatives respectives auxquelles les premières électrodes d'émission (12) sont situées dans le groupe susdit.

5. Transducteur à capacitance selon l'une quelconque des revendications précédentes 1 à 4, caractérisé en ce que les premières électrodes de réception (14) détectent les signaux de sortie produits par les secondes électrodes d'émission (24) en couplage capacitif avec lesdites premières électrodes d'émission(12) en réponse auxdits signaux C.A. de différentes phases pour produire un signal de sortie qui représente une somme du signal de sortie détecté des secondes électrodes, et en ce que
un circuit de mesure (32) est prévu pour obtenir des données de mesure à partir dudit signal de sortie des premières électrodes de réception (14).

6. Transducteur à capacitance selon l'une quelconque des revendications précédentes 1 à 5, caractérisé en ce que sont prévus des moyens générateurs de signaux (30, 34) pour générer un nombre de signaux qui sont les uns par rapport aux autres déphasés successivement de façon incrémentale par étapes de 360° divisés par le nombre de signaux et chacun de ces signaux est appliqué à l'électrode respective parmi les premières électrodes d'émission (12) du groupe susdit d'électrodes d'émission.

7. Transducteur à capacitance selon l'une quelconque des revendications précédentes 1 à 6, caractérisé en ce que les premières électrodes d'émission (12) dans chacun desdits groupes d'électrodes d'émission sont regroupées en au moins deux sous-groupes, les électrodes d'émission dans chacun desdits sous-groupes étant uniformément espacées les unes des autres d'un premier pas et lesdits sous-groupes étant uniformément espacés l'un de l'autre d'un second pas différent dudit premier pas.

8. Transducteur à capacitance selon l'une quelconque des revendications précédentes dépendantes de la revendication 5, caractérisé en ce que le circuit de mesure (32) comprend des moyens (68) pour filtrer les composantes de haute fréquence dudit signal de sortie des premières électrodes de réception (14) pour obtenir un signal de mesure sensiblement sinusoïdal et des moyens (70,72) pour mesurer les phases dudit signal de mesure relativement à l'un desdits signaux C.A. afin d'obtenir les données de mesure.

9. Transducteur à capacitance selon l'une quelconque des revendications précédentes 1 à 8, caractérisé en ce que la première échelle (10) et la seconde échelle (20) sont utilisées comme soit l'échelle de base soit l'échelle de vernier des pieds à coulisse.
